(19) Europäisches Patentamt / European Patent Office / Office européen des brevets

(11) EP 2 756 571 B1

(12) EUROPÄISCHE PATENTSCHRIFT

(45) Veröffentlichungstag und Bekanntmachung des Hinweises auf die Patenterteilung:
06.04.2016 Patentblatt 2016/14

(21) Anmeldenummer: 11779156.6

(22) Anmeldetag: 28.10.2011

(51) Int Cl.:
*H02H 3/38* (2006.01)     *G01R 31/08* (2006.01)
*G01R 31/02* (2006.01)

(86) Internationale Anmeldenummer:
PCT/EP2011/068992

(87) Internationale Veröffentlichungsnummer:
WO 2013/060382 (02.05.2013 Gazette 2013/18)

(54) **VERFAHREN UND SCHUTZGERÄT ZUM ERKENNEN EINES ERDFEHLERS IN EINEM MEHRPHASIGEN ELEKTRISCHEN ENERGIEVERSORGUNGSNETZ MIT KOMPENSIERTEM ODER ISOLIERTEM STERNPUNKT**

METHOD AND PROTECTIVE DEVICE FOR IDENTIFYING A GROUND FAULT IN A POLYPHASE ELECTRICAL ENERGY SUPPLY NETWORK HAVING A COMPENSATED OR ISOLATED STAR POINT

PROCÉDÉ ET APPAREIL DE PROTECTION POUR DÉTECTER UN DÉFAUT À LA TERRE DANS UN RÉSEAU D'ALIMENTATION EN ÉNERGIE ÉLECTRIQUE POLYPHASÉ, POURVU D'UN POINT NEUTRE COMPENSÉ OU ISOLÉ

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(43) Veröffentlichungstag der Anmeldung:
23.07.2014 Patentblatt 2014/30

(73) Patentinhaber: Siemens Aktiengesellschaft
80333 München (DE)

(72) Erfinder:
• LOOS, Matthieu
B-6730 BE-Tintigny (BE)
• MAUN, Jean-Claude
B-1140 Bruessel (BE)

(56) Entgegenhaltungen:
DE-A1- 4 418 124     DE-A1- 19 901 789
DE-B3- 10 302 451

## Beschreibung

Die im Folgenden beschriebene Erfindung ist im Rahmen einer Zusammenarbeit zwischen der Siemens AG und der Fakultät für Angewandte Wissenschaften Bio-, Elektro- und Mechanische Systeme (Faculty of Applied Sciences Bio-, Electro- And Mechanical Systems) der Freien Universität Brüssel ULB (Université Libre de Bruxelles) unter der Leitung von Professor Dr. Maun entwickelt worden.

Die Erfindung betrifft ein Verfahren zum Erkennen eines Erdfehlers in einem mehrphasigen elektrischen Energieversorgungsnetz mit kompensiertem oder isoliertem Sternpunkt, bei dem mittels eines elektrischen Schutzgerätes Nullsystemstrom- und Nullsystemspannungs-Messwerte erfasst werden, die einen an einer Messstelle vorliegenden Nullsystemstrom und eine Nullsystemspannung angeben, wobei die Messstelle im Bereich eines von dem Schutzgerät überwachten Abschnitts des Energieversorgungsnetzes angeordnet ist, und die erfassten Nullsystemstrom- und Nullsystemspannungs-Messwerte in einem Messwertspeicher des Schutzgerätes gespeichert werden. Die Nullsystemspannungs-Messwerte werden mit einem Nullsystemspannungs-Schwellenwert verglichen und es wird ein Triggersignal erzeugt, wenn ein Nullsystemspannungs-Messwert den Nullsystemspannungs-Schwellenwert übersteigt. Bei vorliegendem Triggersignal wird ein Verlauf von Nullsystemstrom-Messwerten aus dem Messwertspeicher ausgewählt und ein Verlauf von Nullsystemladungs-Werten aus dem Verlauf der ausgewählten Nullsystemstrom-Messwerte berechnet. Der Verlauf der Nullsystemladungs-Werte wird zum Erkennen eines Erdfehlers in dem überwachten Abschnitt herangezogen. Die Erfindung betrifft auch ein Schutzgerät zum Erkennen eines Erdfehlers in einem mehrphasigen elektrischen Energieversorgungsnetz mit kompensiertem oder isoliertem Sternpunkt mit einer entsprechend eingerichteten Steuereinrichtung.

Die selektive Erkennung von Erdfehlern in Energieversorgungsnetzen mit isoliertem oder kompensiertem (auch als "gelöscht" bezeichnet) Sternpunkt ist auch heutzutage noch eine herausfordernde Aufgabe. Schwierigkeiten bei der Erkennung solcher Erdfehler liegen unter anderem an lediglich kleinen Fehlerströmen aufgrund der jeweiligen Sternpunktbehandlung und/oder hohen Fehlerimpedanzen. Diese Ursachen können im schlimmsten Fall zu Fehlentscheidungen bei der Erdfehlerüberwachung führen.

Zur Erdfehlererkennung werden heutzutage beispielsweise sogenannte "Erdschlusswischerrelais" eingesetzt. Diese führen eine Erkennung des Erdfehlers anhand der in den ersten Millisekunden nach Eintritt des Erdfehlers auftretenden transienten Einschwingvorgänge von aufgenommenen Summenstrom- und Verlagerungsssspannungssignalen durch. Hierdurch kann - solange die untersuchten Signale ausreichend stark ausgebildet sind - eine sichere Erkennung des Erdfehlers und der Richtung, in der der Erdfehler aufgetreten ist, stattfinden. Eine Schwäche des Erdschlusswischerverfahrens liegt hingegen darin, dass nur Fehler mit geringen Fehlerimpedanzen (bis etwa 50 Ohm) sicher erkannt werden können.

Beim sogenannten wattmetrischen Verfahren wird der Einschwingvorgang abgewartet und die Erdfehlererkennung anhand des stationären Reststroms durchgeführt. Mit dem wattmetrischen Verfahren können auch Erdfehler mit Fehlerimpedanzen bis zu etwa 5 kOhm sicher erkannt werden. Schwierigkeiten können hierbei jedoch beispielsweise bei Sammelschienenabgängen mit vergleichsweise hohen kapazitiven Erdströmen auftreten, da Phasenwinkelfehler in der Messkette bewirken können, dass Anteile des kapazitiven Erdstromes als ohmscher Reststrom erkannt werden, was zu Fehlentscheidungen bei der Erdfehlererkennung führen kann. Außerdem können mit dem wattmetrischen Verfahren üblicherweise keine intermittierenden (pulsierenden und selbstständig verlöschenden) Erdfehler erkannt werden.

Ein Verfahren der eingangs genannten Art geht beispielsweise aus der deutschen Patentschrift DE 103 02 451 B3 hinsichtlich der Erkennung von Erdfehlern in Sammelschienenabgängen hervor. Bei dem hier beschriebenen Verfahren wird die Erkennung eines Erdfehlers durch eine Betrachtung der durch die Funktion $q_0=f(u_0)$ beschriebenen Gerade bzw. Kurve durchgeführt. Weist die Gerade eine positive Steigung auf oder ist die Kurve bis zum ersten Maximum linksdrehend, so wird auf einen fehlerfreien Abgang geschlossen. Weist die Gerade hingegen eine negative Steigung auf oder ist die Kurve bis zum ersten Maximum rechtsdrehend, so wird auf einen fehlerbehafteten Abgang geschlossen. Mit dem beschriebenen Verfahren lassen sich auch hochohmige und wiederzündende bzw. intermittierende Erdfehler erkennen.

Diese Patentschrift DE 103 02 451 B3 bildet den Oberbegriff des Anspruchs 1.

Der Erfindung liegt die Aufgabe zugrunde, ein Verfahren der eingangs genannten Art sowie ein entsprechendes elektrisches Schutzgerät anzugeben, um Erdfehler mit noch größerer Empfindlichkeit erkennen zu können.

Diese Aufgabe wird erfindungsgemäß durch ein gattungsgemäßes Verfahren gemäß des Anspruchs 1 gelöst, bei dem zum Erkennen eines Erdfehlers unter Verwendung des Verlaufs von Nullsystemladungs-Werten und (zeitlich) zugehörigen Nullsystemspannungs-Messwerten ein Nullsystemkapazitäts-Wert für den überwachten Abschnitt bestimmt wird, unter Verwendung des Verlaufs von Nullsystemladungs-Werten und des Nullsystemkapazitäts-Wertes einerseits sowie der zugehörigen Nullsystemspannungs-Messwerte andererseits ein Abweichungskennwert gebildet wird und ein auf einen Erdfehler auf dem überwachten Abschnitt hinweisendes Fehlersignal erzeugt wird, wenn der Abweichungskennwert einen vorgegebenen ersten Abweichungs-Schwellenwert übersteigt.

Der Erfindung liegt die Erkenntnis zugrunde, dass fehlerfreie Abschnitte des elektrischen Energieversorgungsnetzes, beispielsweise fehlerfreie Sammelschienenabgänge, sich annähernd wie Kapazitäten verhalten, da der Nullsystemstrom einzig durch die Phase-Erde-Kapazitäten fließen kann, während andere Impedanzen in diesem Fall vernachlässigt werden können. Ein fehlerbehafteter Abschnitt des Energieversorgungsnetzes hingegen verhält sich nicht wie eine Kapazität, da die Phase-Erde-Kapazitäten durch den Erdfehler überbrückt sind. Durch automatische Bestimmung der Nullsystemkapazität des überwachten Abschnitts und die Bildung des Abweichungskennwertes lässt sich leicht überprüfen, ob sich der überwachte Abschnitt wie eine Kapazität verhält oder nicht. Je nach Einstellung des ersten Abweichungskennwertes kann daraus mit hoher Empfindlichkeit eine Entscheidung getroffen werden, ob ein Erdfehler auf dem überwachten Abschnitt vorliegt. Geeignete Werte für den ersten Abweichungs-Kennwert liegen zwischen etwa -100V und etwa +100V.

Dadurch dass außerdem bei dem erfindungsgemäßen Verfahren eine automatische Ermittlung der Nullsystemkapazität durchgeführt wird, muss diese nicht durch den Betreiber des Energieversorgungsnetzes als voreingestellter Parameter vorgegeben werden. Dies stellt insbesondere deswegen einen Vorteil dar, weil viele Netzbetreiber die Werte für die Nullsystemkapazität nicht mit ausreichender Genauigkeit kennen und die Nullsystemkapazität außerdem je nach vorliegender Netztopologie des Energieversorgungsnetzes, die sich mit jeder vorgenommenen Schalthandlung verändert, unterschiedliche Werte annimmt. Durch die automatische Ermittlung der Nullsystemkapazität im Fehlerfall kann die Betrachtung dynamisch und damit sehr empfindlich durchgeführt werden.

Gemäß einer vorteilhaften Ausführungsform des erfindungsgemäßen Verfahrens ist vorgesehen, dass zur Bildung des Abweichungskennwertes der Quotient der Nullsystemladungs-Werte und des Nullsystemkapazitäts-Wertes gebildet und dieser von den zeitlich zugehörigen Nullsystemspannungs-Messwerten abgezogen wird.

Auf diese Weise lässt sich ausschließlich anhand vorhandener Größen, nämlich der bekannten Verläufe von Nullsystemspannung und Nullsystemladung sowie dem ermittelten Wert für die Nullsystemkapazität, ein geeigneter Abweichungskennwert bilden, der für die Erdfehlererkennung herangezogen werden kann.

Eine weitere vorteilhafte Ausführungsform des erfindungsgemäßen Verfahrens sieht vor, dass als Startzeitpunkt, zu dem der ausgewählte Verlauf der Nullsystemstrom-Messwerte beginnt, entweder derjenige Zeitpunkt gewählt wird, zu dem der letzte Nulldurchgang der Nullsystemspannungs-Messwerte stattgefunden hat, oder derjenige Zeitpunkt gewählt wird, der eine vorgegebene Zeitdauer vor dem Zeitpunkt liegt, zu dem die Überschreitung des Nullsystemspannungs-Schwellenwertes stattgefunden hat.

Auf diese Weise lässt sich sehr einfach ein Zeitpunkt ermitteln, ab dem der Verlauf der Nullsystemstrom-Messwerte für die Erdfehlererkennung herangezogen werden soll. Die für die zweite Alternative zu verwendende vorgegebene Zeitdauer kann beispielsweise etwa 3-7 Millisekunden, vorzugsweise etwa 5 Millisekunden, betragen.

In diesem Zusammenhang sieht eine weitere vorteilhafte Ausführungsform des erfindungsgemäßen Verfahrens zudem vor, dass der Verlauf der Nullsystemladungs-Werte durch numerische zeitliche Integration des Verlaufs der Nullsystemstrom-Messwerte ab dem Startzeitpunkt ermittelt wird.

Konkret kann es sich bei dem Integrationsverfahren z.B. um eine numerische Integration unter Verwendung der an sich bekannten Trapezregel handeln.

Eine weitere vorteilhafte Ausführungsform des erfindungsgemäßen Verfahrens sieht zudem vor, dass der Nullsystemkapazitäts-Wert aus einem über ein Zeitfenster festgelegten Bereich der Nullsystemladungs-Werte und der zugehörigen Nullsystemspannungs-Messwerte gebildet wird, wobei das Zeitfenster zum Startzeitpunkt beginnt und nach Ablauf einer vorgegebenen Fensterzeit endet.

Durch die Verwendung eines begrenzten Zeitfensters zur Ermittlung des Nullsystemkapazitäts-Wertes kann dessen Ermittlung besonders effektiv erfolgen. Für die vorgegebene Fensterzeit kann beispielsweise ein Wert von etwa 20 Millisekunden verwendet werden.

Konkret kann in diesem Zusammenhang beispielsweise vorgesehen sein, dass der Nullsystemkapazitäts-Wert mittels eines Least-Square-Schätzverfahrens aus den Nullsystemladungs-Werten und den zeitlich zugehörigen Nullsystemspannungs-Messwerten bestimmt wird.

Durch den an sich bekannten Least-Square-Schätzer wird quasi der Verlauf der Nullsystemladungs-Werte über den zugehörigen Nullsystemspannungs-Messwerten als Gerade angenähert, deren Steigung den Wert für die Nullsystemkapazität ergibt.

Gemäß einer weiteren vorteilhaften Ausführungsform des erfindungsgemäßen Verfahrens ist zudem vorgesehen, dass der Nullsystemkapazitäts-Wert mit einem oberen und einem unteren Kapazitäts-Schwellenwert verglichen wird und bei Überschreitung des oberen Kapazitäts-Schwellenwertes der Wert des oberen Kapazitäts-Schwellenwertes und bei Unterschreitung des unteren Kapazitäts-Schwellenwertes der Wert des unteren Kapazitäts-Schwellenwertes als Nullsystemkapazitäts-Schwellenwert verwendet wird.

Bei entsprechender Wahl des oberen und des unteren Kapazitäts-Schwellenwertes kann hierdurch einerseits sichergestellt werden, dass der Nullsystemkapazitäts-Wert stets einen positiven Wert annimmt. Hierdurch wird die korrekte Erkennung eines Erdfehlers weiter unterstützt. Außerdem kann durch die Eingrenzung des für die Erkennung verwendeten Nullsystemkapazitäts-Schwellenwertes eine Erhöhung der Empfindlichkeit des Verfahrens stattfinden, da bei der Ermittlung des Nullsystemkapazitäts-Schwellenwertes aus den Nullsystemladungs-Werten und den Nullsystemspannungs-Messwerten hierdurch mögliche unplausible (d.h. zu große oder zu kleine) Werte für die Nullsystemkapazität ausgeschlossen werden. Die Werte für den oberen und den unteren Kapazitäts-Schwellenwert sollten derart gewählt werden, dass die Nullsystemkapazität eines fehlerfreien Abschnitts des Energieversorgungsnetzes üblicherweise innerhalb dieser Grenzen liegt und lediglich bei einem fehlerbehafteten Abschnitt eine Anpassung erfolgt. Geeignete Werte für einen oberen Kapazitäts-Schwellenwert liegen zwischen etwa $2\mu F$ und etwa $200\mu F$, während geeignete Werte für einen unteren Kapazitäts-Schwellenwert zwischen etwa $0,01\mu F$ und etwa $2\mu F$ liegen.

Eine weitere vorteilhafte Ausführungsform des erfindungsgemäßen Verfahrens sieht zudem vor, dass ein zeitliches Integral über das Quadrat der jeweils ermittelten Abweichungskennwerte gebildet wird und das Fehlersignal auch dann erzeugt wird, wenn das zeitliche Integral über das Quadrat der Abweichungskennwerte einen vorgegeben zweiten Abweichungs-Schwellenwert übersteigt.

Hierdurch kann die Empfindlichkeit des erfindungsgemäßen Verfahrens weiter erhöht werden, da hierbei eine Betrachtung über eine längere Zeit durchgeführt werden kann. Durch die Quadrierung der Abweichungskennwerte können starke Abweichungen gegenüber kleineren betont werden; die zeitliche Integration über aufeinander folgende Abweichungskennwerte erlaubt zudem auch die Erkennung sich nur durch geringe Abweichungen auswirkender Erdfehler. Als zweiter Abweichungs-Schwellenwert kann beispielsweise der inverse Wert der Nullsystemkapazität oder ein dazu proportionaler Wert verwendet werden. Der für den zweiten Abweichungs-Schwellenwert zu verwendende Wert kann durch Auswahl eines minimalen und eines maximalen Wertes begrenzt werden, um in bestimmten Fällen - z.B. bei sehr langen oder kurzen Leitungen - ein robustes Verhalten zu zeigen. In diesem Zusammenhang kann gemäß einer weiteren vorteilhaften Ausführungsform des erfindungsgemäßen Verfahrens zudem vorgesehen sein, dass der Gradient des Verlaufs der Nullsystemstrom-Messwerte untersucht wird und der Wert des zweiten Abweichungs-Schwellenwertes derart dynamisch an den Wert des Gradienten angepasst wird, dass bei einem hohen Gradienten ein höherer Wert für den zweiten Abweichungs-Schwellenwert verwendet wird als bei einem niedrigen Gradienten.

Hierdurch kann eine Anpassung der Empfindlichkeit der Erkennung eines Erdfehlers an die jeweilige Fehlersituation stattfinden. Hierzu werden die transienten Vorgänge im Verlauf der Nullsystemstrom-Messwerte betrachtet. Bei einem niederohmigen Erdfehler wird nämlich zum Fehlerbeginn ein hoher Gradient des Verlaufes der Nullsystemstrom-Messwerte auftreten, während der Gradient bei einem hochohmigen Erdfehler eher moderat verläuft. Hierdurch kann eine automatische Erkennung der Fehlersituation erfolgen. Um bei einem niederohmigen Erdfehler die Erkennung möglichst robust zu halten und nicht zu früh ein Fehlersignal zu erzeugen, wird der zweite Abweichungs-Schwellenwert in diesem Fall höher angesetzt als bei einem hochohmigen Erdfehler, bei dem das Verfahren mit höchstmöglicher Empfindlichkeit arbeiten soll. Die Betrachtung des Gradienten kann auf Momentanwertbasis erfolgen oder unter Verwendung von Mittelwerter (z.B. RMS-Werten) durchgeführt werden.

Außerdem kann konkret vorgesehen sein, dass das zeitliche Integral über das Quadrat der Abweichungskennwerte nach Ablauf einer vorgegebenen Überwachungszeitdauer auf Null zurückgesetzt wird.

Hierdurch kann eine Fehlentscheidung aufgrund eines allmählichen Driftens des zeitlichen Integrals über das Quadrat der Abweichungskennwerte in Richtung des zweiten Abweichungs-Schwellenwertes verhindert werden. Als Überwachungszeitdauer kann beispielsweise die Dauer von 5 Zyklen der Grundschwingung des Stromes (bei einer Grundschwingung von 50Hz also 100 Millisekunden) verwendet werden. Nach dem Zurücksetzen wird die Bildung des Integrals erneut gestartet.

Um eine Fehlentscheidung bei der Erdfehlererkennung aufgrund für die Auswertung nicht geeigneter Nullsystemstrom- und/oder Nullsystemspannungs-Messwerte zu vermeiden, kann gemäß einer weiteren vorteilhaften Ausführungsform des erfindungsgemäßen Verfahrens außerdem vorgesehen sein, dass das Verfahren dann unterbrochen wird, wenn ein Mittelwert der Nullsystemstrom-Messwerte unter einem vorgegebenen Minimalstrom-Schwellenwert und/oder ein Mittelwert der Nullsystemspannungs-Schwellenwerte unter einem vorgegebenen Minimalspannungs-Schwellenwert liegt.

Der jeweilige Mittelwert kann beispielsweise als RMS-Wert (RMS = root mean square) bestimmt werden.

Eine weitere vorteilhafte Ausführungsform des erfindungsgemäßen Verfahrens sieht außerdem vor, dass zur Erkennung einer Richtung, in der der Erdfehler von der Messstelle aus gesehen aufgetreten ist, für eine vorgegebene Betrachtungszeitdauer ab dem Startzeitpunkt eine Nullsystemwirkenergie ermittelt und mit einem Wirkenergie-Schwellenwert verglichen wird, ein in Vorwärtsrichtung auf dem überwachten Abschnitt liegender Erdfehler dann erkannt wird, wenn die ermittelte Nullsystemwirkenergie den negativen Wirkenergie-Schwellenwert unterschreitet, und ein in Rückwärtsrichtung außerhalb des überwachten Abschnitts liegender Erdfehler dann erkannt wird, wenn die ermittelte Nullsystemwirkenergie den positiven Wirkenergie-Schwellenwert überschreitet.

Auf diese Weise kann die Erkennung des Erdfehlers durch eine zusätzliche Angabe der Fehlerrichtung weiter unterstützt werden. Die Nullsystemwirkenergie kann beispielsweise durch Integration einer Nullsystemwirkenergie über eine vorgegebene Zeitdauer (z.B. 20ms nach Fehlereintritt) berechnet werden. Die oben genannten Aufgabe wird auch durch ein Schutzgerät zum Erkennen eines Erdfehlers in einem mehrphasigen elektrischen Energieversorgungsnetz mit kompensiertem oder isoliertem Sternpunkt gelöst, das eine Steuereinrichtung aufweist, die zur Durchführung eines Verfahrens gemäß einem der Ansprüche 1 bis 11 eingerichtet ist.

Hinsichtlich der Vorteile des erfindungsgemäßen Schutzgerätes wird auf die bezüglich des Verfahrens vorstehend gemachten Ausführungen verwiesen.

Außerdem wird die oben genannte Aufgabe durch die Verwendung eines Schutzgerätes gemäß Anspruch 12 zur Überwachung eines Abgangs in einem elektrischen Energieversorgungsnetz mit kompensiertem oder isoliertem Sternpunkt auf einen Erdfehler gelöst.

Die Erfindung wird im Folgenden anhand eines Ausführungsbeispiels näher erläutert. Hierzu zeigen

Figur 1: eine schematische Darstellung eines Teils eines elektrischen Energieversorgungsnetzes;

Figur 2: ein schematisches Ablaufdiagramm zur Erläuterung des Ablaufs eines Verfahrens zur Erkennung eines Erdfehlers;

Figur 3: einen beispielhaften Verlauf einer Nullsystemspannung in dem Energieversorgungsnetz in Figur 1;

Figur 4: beispielhafte Verläufe von Nullsystemströmen in drei Abgängen des Energieversorgungsnetzes in Figur 1;

Figur 5: beispielhafte Verläufe von aus den Nullsystemströmen ermittelten Nullsystemla-dungen;

Figur 6: beispielhafte Werte von ermittelten Nullsystemkapazitäten;

Figur 7: beispielhafte Verläufe von Abweichungskennwerten; und

Figur 8: beispielhafte Verläufe der Integrale quadrierter Abweichungskennwerte.

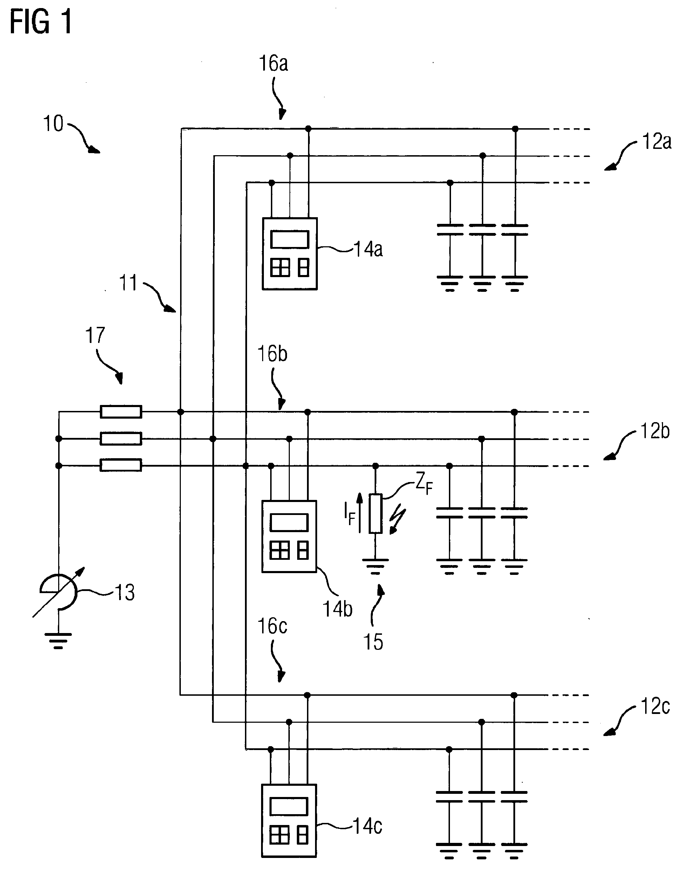

Figur 1 zeigt in schematischer Darstellung einen Teil eines ansonsten nicht näher dargestellten dreiphasigen elektrischen Energieversorgungsnetzes 10 mit einer Sammelschiene 11 und drei von der Sammelschiene ausgehenden Abgängen 12a-c. Die Abgänge 12a-c weisen Phase-Erde-Kapazitäten auf, die in Figur 1 lediglich schematisch angedeutet sind. Ein Transformator zur Speisung der Sammelschiene 11 ist durch die entsprechenden Transformatorimpedanzen 17 angedeutet. Der Sternpunkt des Energieversorgungsnetzes 10 ist - wie in Figur 1 angedeutet - kompensiert (auch als "gelöscht" bezeichnet), d.h. er ist über eine Induktivität 13, z.B. eine sogenannte Petersen-Spule, mit Erde verbunden. Dieser Fall ist in Figur 1 lediglich beispielhaft ausgewählt, es kann sich bei dem Energieversorgungsnetz 10 um ein beliebiges Energieversorgungsnetz mit kompensiertem oder isoliertem Sternpunkt handeln. Die Abgänge 12a-c werden von elektrischen Schutzgeräten 14a-c hinsichtlich des Auftretens eines Erdfehlers überwacht. Hierzu sind die Schutzgeräte 14a-c an Messstellen 16a-c angeordnet und mit entsprechenden - in Figur 1 nur angedeuteten - Strom- und Spannungswandlern gekoppelt. Sollte ein Erdfehler erkannt worden sein, so kann der entsprechende Abgang von dem jeweiligen Schutzgerät 14a-c über in Figur 1 nicht dargestellte Leistungsschalter abgeschaltet werden. Alternativ oder zusätzlich dazu kann von dem jeweiligen Schutzgerät 14a-c auch eine Ereignismeldung generiert werden, die den erkannten Erdfehler an den Betreiber des Energieversorgungsnetzes (z.B. an eine übergeordnete Leitstelle) meldet, um eine Behebung der Fehlerursache (z.B. eine schadhafte Isolierung eines Erdkabels oder ein in eine Freileitung gestürzter Baum) zu veranlassen.

Lediglich beispielhaft soll in Figur 1 angenommen werden, dass im zweiten Abgang 12b ein Erdfehler 15 aufgetreten ist, der die Fehlerimpedanz $Z_F$ aufweist. Der Erdfehler 15 bewirkt einen Fehlerstrom $I_F$, der über die Fehlerimpedanz $Z_F$ fließt und die Kapazität des betroffenen Phasenleiters überbrückt. Dies bewirkt einen Stromfluss über die Induktivität 13. und eine transiente Aufladung der jeweils anderen Phasenleiter des fehlerbehafteten Abgangs 12b, aber auch der nicht von dem Erdfehler betroffenen Abgänge 12a und 12c.

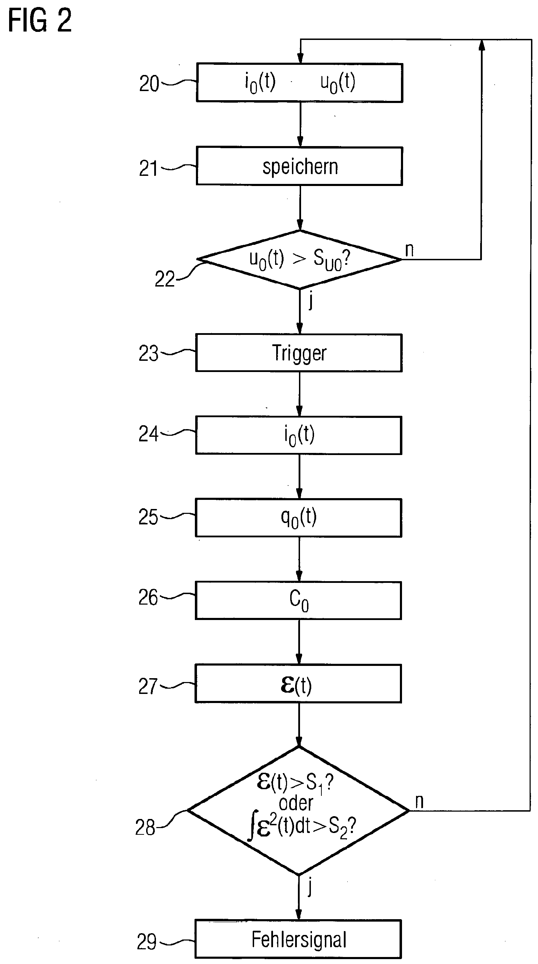

Anhand der Figuren 2 bis 8 soll im Folgenden die Vorgehensweise zur Erkennung eines Erdfehlers in dem Energieversorgungsnetz 10 erläutert werden. Dem nachfolgend beschriebenen Verfahren liegt die Erkenntnis zugrunde, dass jeder gesunde, d.h. nicht von einem Erdfehler betroffene, Abschnitt eines Energieversorgungsnetzes annähernd wie eine Kapazität behandelt werden kann, für die die proportionale Beziehung (1) zwischen der Nullsystemladung $Q_0$ und der Nullsystemspannung $U_0$ gemäß

$$Q_0 = C_0 \cdot U_0 \qquad\qquad (1)$$

erfüllt ist, wobei der Proportionalitätsfaktor $C_0$ die Nullsystemkapazität angibt. Diese Gleichung ist für den gesunden Abschnitt eines Energieversorgungsnetzes erfüllt, da der einzeige Weg, über den der Nullsystemstrom zirkulieren kann, derjenige über die Phase-Erde-Kapazitäten ist. Andere Impedanzen können in diesem Fall vernachlässigt werden. Im fehlerbehafteten Fall wird die Phase-Erde-Kapazität der betroffenen Phase jedoch durch den Erdfehler überbrückt, so dass Beziehung (1) nicht mehr als gültig angesehen werden kann.

Folglich kann bei bekannten Werten für die Nullsystemladung, die Nullsystemspannung und die Nullsystemkapazität durch eine Überprüfung, ob sich der von dem jeweiligen Schutzgerät 14a-c überwachte Abschnitt entsprechend einer Kapazität verhält, eine Unterscheidung zwischen einem fehlerbehafteten Abschnitt (Abschnitt verhält sich nicht wie eine Kapazität) und einem gesunden Abschnitt (Abschnitt verhält sich wie eine Kapazität) getroffen werden.

Gemäß Figur 2 werden für diese Überprüfung von dem jeweiligen Schutzgerät die nachfolgend beschriebenen Schritte durchgeführt. Zunächst werden gemäß einem ersten Schritt 20 Nullsystemstrom-Messwerte $i_0(t)$ und Nullsystemspannungs-Messwerte $u_0(t)$ für jeden überwachten Abschnitt, in Figur 1 also für jeden Abgang 12a-c, erfasst. Hierzu werden über analoge Wandler (oder andere Sensoren, z.B. sogenannte Nichtkonventionelle Wandler) Strom- und Spannungssignale an den Messstellen 16a-c erfasst, die nachfolgend abgetastet und in digitale Verläufe von Nullsystemstrom-Messwerten und Nullsystemspannungs-Messwerten umgewandelt werden. Die Ermittlung der Nullsystemgrößen kann entweder bereits wandlerseitig (z.B. Erfassung des Nullstromes durch einen Umbauwandler) erfolgen oder rechnerisch in dem Schutzgerät oder einem vorgeordneten Messgerät (z.B. einer sogenannten "Merging-Unit") anhand der phasenleiterbezogenen Messwerte durchgeführt werden. Da die Nullsystemspannung üblicherweise entlang der Sammelschiene 11 einen konstanten Wert besitzen wird, ist es darüber hinaus ausreichend, die Nullsystemspannungs-Messwerte an der Sammelschiene zu erfassen, während die Nullsystemstrom-Messwerte hingegen direkt an den einzelnen Messstellen 16a-c erfasst werden müssen.

In einem folgenden Schritt 21 werden die erfassten Nullsystemstrom- und Nullsystemspannungs-Messwerte in einem Messwertspeicher des jeweiligen Schutzgerätes 12a-c abgelegt. Bei diesem Messwertspeicher kann es sich beispielsweise um einen Ringspeicher handeln, bei dem nach Erreichen der maximalen Speicherbelegung jeweils die ältesten gespeicherten Messwerte mit den jeweils jüngsten Messwerten überschrieben werden.

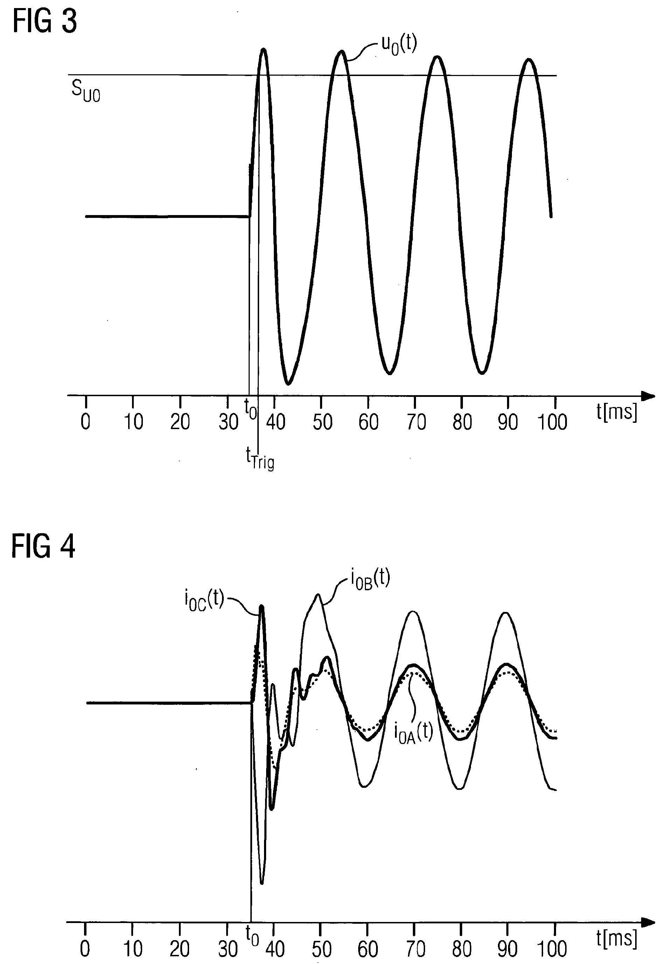

Die Nullsystemspannungs-Messwerte $u_0(t)$ werden in einem folgenden Schritt 22 daraufhin überprüft, ob sie einen vorgegebenen Nullsystemspannungs-Schwellenwert $S_{U0}$ überschreiten. Hierbei können beispielsweise Momentanwerte der Nullspannung oder auch gleitende Mittelwerte (z.B. RMS-Werte) betrachtet werden. Die Überprüfung der Nullsystemspannungs-Messwerte gegen den Nullsystemspannungs-Schwellenwert $S_{U0}$ ist auch in dem in Figur 3 dargestellten Diagramm gezeigt. In Figur 3 erkennt man zum Zeitpunkt $t_{Trig}$ eine Überschreitung des Nullsystemspannungs-Schwellenwertes durch die Nullsystemspannungs-Messwerte. Eine Überschreitung des Nullsystemspannungs-Schwellenwerts $S_{U0}$ wird als Hinweis auf einen vorliegenden Erdfehler gewertet und führt gemäß einem nachfolgenden Schritt 23 zu der Erzeugung eines einen Erdkurzschluss angebenden Triggersignals. Wird hingegen keine Überschreitung des Nullsystemspannungs-Schwellenwertes $S_{U0}$ erkannt, so wird das Verfahren ohne Generierung eines Triggersignals bei Schritt 20 mit der Erfassung weiterer Nullsystemstrom- und Nullsystemspannungs-Messwerte fortgesetzt.

In einem folgenden Schritt 24 wird ein Verlauf von Nullsystemstrom-Messwerten ausgewählt, dessen Beginn mit dem Eintritt des Erdfehlers möglichst dicht zusammenfällt, so dass die die Vorgänge während des Erdfehlers untersucht werden können. Hierzu wird ein Startzeitpunkt $t_0$ festgelegt, zu dem der Verlauf der Nullsystemstrom-Messwerte beginnen soll. Dieser Startzeitpunkt $t_0$ kann entweder dadurch festgelegt werden, dass die in dem Messwertspeicher des jeweiligen Schutzgerätes 14a-c gespeicherten Nullsystemspannungs-Messwerte auf ihren letzten Nulldurchgang untersucht werden und der Startzeitpunkt $t_0$ entsprechend auf den Zeitpunkt dieses Nulldurchgangs gelegt wird. Dies ist in Figur 3 beispielhaft angedeutet. Alternativ kann der Startzeitpunkt $t_0$ als derjenige Zeitpunkt festgelegt werden, der eine vorgegebene Zeitdauer vor dem Zeitpunkt $t_{Trig}$ der Überschreitung des Nullsystemspannungs-Schwellenwertes $S_{U0}$ liegt. Die vorgegebene Zeitdauer kann beispielsweise etwa 5 ms betragen. Der Verlauf von Nullsystemstrom-Messwerten kann entweder gleitend auf den jeweiligen aktuellen Messzeitpunkt oder durch Vorgabe einer festen Verlaufsdauer (z.B. mittels eines Messfensters von 20ms Dauer) nach dem Startzeitpunkt $t_0$ festgelegt werden. Die ggf. verwendeten Messfenster können auch überlappend angeordnet sein. In Figur 4 sind lediglich beispielhaft die Verläufe der Nullsystemstrom-Messwerte für die drei Abgänge 12a-c (vgl. Figur 1) gezeigt, wobei $i_{0A}(t)$ die Nullsystemstrom-Messwerte am ersten Abgang 12a, $i_{0B}(t)$ die Nullsystemstrom-Messwerte am zweiten Abgang 12b, und $i_{0C}(t)$ die Nullsystemstrom-Messwerte am dritten Abgang 12c darstellen. Man erkennt den auffälligen Verlauf der Nullsystemstrom-Messwerte $i_{0B}(t)$ für den fehlerbehafteten zweiten Abgang 12b. Außerdem ist gut erkennbar, dass sich für die Verläufe der Nullsystemstrom-Messwerte aller drei Abgänge nach einer transienten Übergangsphase ab ca. 20ms nach $t_0$ vergleichsweise stabile Zustände einstellen. In Figur 4 ist kein fester Endzeitpunkt für den jeweiligen Verlauf der Nullsystemstrom-Messwerte vorgesehen, so dass mit jedem neu erfassten Nullsystemstrom-Messwert der Verlauf entsprechend gleitend verlängert wird.

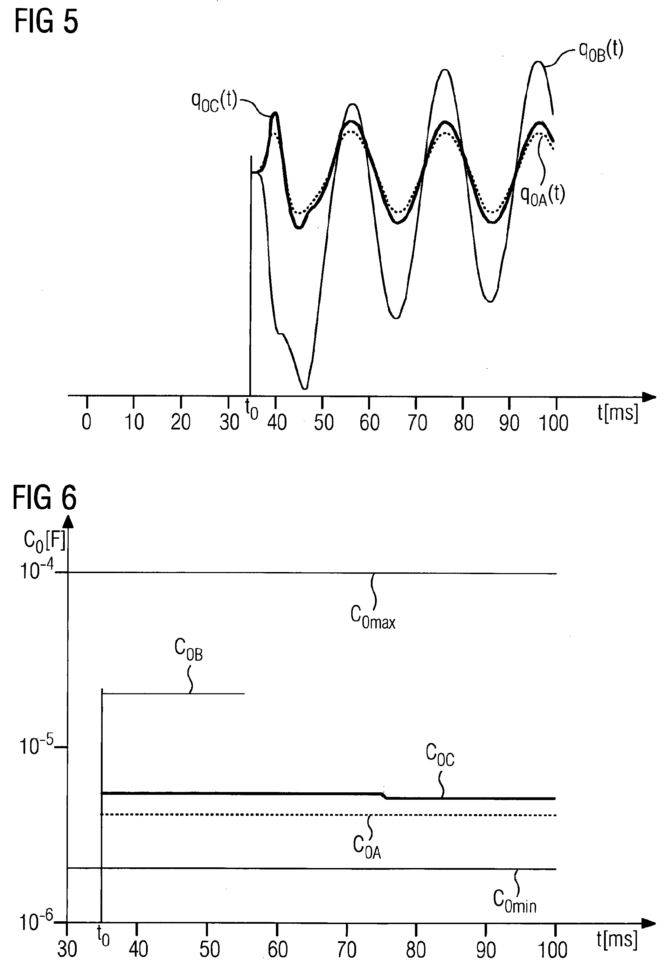

In einem weiteren Schritt 25 wird aus dem jeweiligen Verlauf von Nullsystemstrom-Messwerten $i_0(t)$ ein jeweiliger Verlauf von Nullsystemladungs-Werten $q_0(t)$ berechnet. Dies kann beispielsweise durch numerische zeitliche Integration des Verlaufs der Nullsystemstrom-Messwerte erfolgen, z.B. kann hierfür eine numerische Integration nach der an sich bekannten Trapezregel durchgeführt werden. Das Ergebnis der Berechnung des jeweiligen Verlaufs von Nullsystemladungs-Werten ist beispielhaft in Figur 5 dargestellt, hierbei bezeichnet $q_{0A}(t)$ den Verlauf der Nullsystemladungs-Werte für den ersten Abgang 12a, $q_{0B}(t)$ den Verlauf der Nullsystemladungs-Werte für den zweiten Abgang 12b und $q_{0C}(t)$

den Verlauf der Nullsystemladungs-Werte für den dritten Abgang 12c.

In einem weiteren Schritt 26 wird nachfolgend anhand des in Schritt 25 jeweils ermittelten Verlaufs von Nullsystemladungs-Werten und im Messwertspeicher des jeweiligen Schutzgerätes 14a-c abgespeicherten zeitlich zugehörigen Nullsystemspannungs-Messwerten ein Nullsystemkapazitäts-Wert $C_0$ für jeden Abgang 12a-c bestimmt. Hierfür bietet sich die Festlegung eines Zeitfensters an, das beispielsweise zum Startzeitpunkt $t_0$ beginnt und nach Ablauf einer vorgegebenen Fensterzeit, z.B. nach 20ms, endet. Die Bestimmung des Nullsystemkapazitäts-Wertes $C_0$ kann beispielsweise durch eine Schätzung mit der an sich bekannten Least-Square-Methode (Methode der kleinsten Fehlerquadrate) erfolgen. Hierbei wird quasi der Verlauf der Nullsystemladungs-Werte über den zugehörigen Nullsystemspannungs-Messwerten als Gerade angenähert, deren Steigung den Wert für die Nullsystemkapazität ergibt. Wenn der Verlauf der Geraden nicht durch den Ursprung gehen sollte, wird bei der Ermittlung durch die Least-Square-Methode zur Korrektur auch ein Offset-Wert off ermittelt:

$$u_0(t) = q_0(t) / C_0 + off \qquad (2)$$

In Figur 6 ist das Ergebnis der Bestimmung des Nullsystemkapazitäts-Wertes $C_{0B}$ für den zweiten Abgang 12b während eines bei $t_0$ startenden Zeitfensters mit einer Fensterdauer von 20ms beispielhaft dargestellt. Zum Vergleich sind in Figur 6 auch die Werte für die Nullsystemkapazität $C_{0A}$ und $C_{0C}$ dargestellt, die sich für die gesunden Abgänge 12a und 12c ergeben würden.

Zur Unterstützung des Verfahrens zur Erkennung des Erdfehlers kann vorgesehen sein, dass der bestimmte Wert für die Nullsystemkapazität in einem vorgegebenen Bereich liegen muss, beispielsweise zwischen einem oberen Kapazitäts-Schwellenwert $C_{0max}$ und einem unteren Kapazitäts-Schwellenwert $C_{0min}$, die in Figur 6 lediglich beispielhaft eingetragen sind. Wenn der ermittelte Nullsystemkapazitäts-Wert oberhalb des oberen oder unterhalb des unteren Kapazitäts-Schwellenwertes liegen würde, so würde zur Stabilisierung des Verfahrens der jeweils verletzte Kapazitäts-Schwellenwert als Wert für die Nullsystemkapazität angesetzt werden.

Bei entsprechender Wahl des oberen und des unteren Kapazitäts-Schwellenwertes kann hierdurch einerseits sichergestellt werden, dass der Nullsystemkapazitäts-Wert stets einen positiven Wert annimmt. Hierdurch wird die korrekte Erkennung eines Erdfehlers weiter unterstützt. Außerdem kann durch die Eingrenzung des für die Erkennung verwendeten Nullsystemkapazitäts-Schwellenwertes eine Erhöhung der Empfindlichkeit des Verfahrens stattfinden, da bei der Ermittlung des Nullsystemkapazitäts-Schwellenwertes aus den Nullsystemladungs-Werten und den Nullsystemspannungs-Messwerten hierdurch mögliche unplausible (d.h. zu große oder zu kleine) Werte für die Nullsystemkapazität ausgeschlossen werden. Die Werte für den oberen und den unteren Kapazitäts-Schwellenwert sollten derart gewählt werden, dass die Nullsystemkapazität eines fehlerfreien Abschnitts des Energieversorgungsnetzes üblicherweise innerhalb dieser Grenzen liegt und lediglich bei einem fehlerbehafteten Abschnitt eine Anpassung erfolgt.

In einem nachfolgenden Schritt 27 wird aus dem Verlauf von Nullsystemladungs-Werten und dem Nullsystemkapazitäts-Wert einerseits und den zugehörigen Nullsystemspannungs-Messwerten andererseits ein Abweichungs-Kennwert $\varepsilon(t)$ gebildet. Der Abweichungs-Kennwert dient zur Bewertung dahingehend, ob sich der jeweilige Abgang 12a-c wie eine Kapazität verhält. Hiermit wird quasi bewertet, ob sich mit der in Schritt 26 ermittelten Nullsystemkapazität eine proportionale Beziehung zwischen den aus den Nullsystemstrom-Messwerten bestimmten Nullsystemladungs-Werten und den durch Messung ermittelten Nullsystemspannungs-Messwerten beschreiben lässt. Der Abweichungs-Kennwert $\varepsilon(t)$ kann beispielsweise gemäß folgender Vorschrift bestimmt werden:

$$\varepsilon(t) = u_0(t) - q_0(t) / C_0 - off \qquad (3)$$

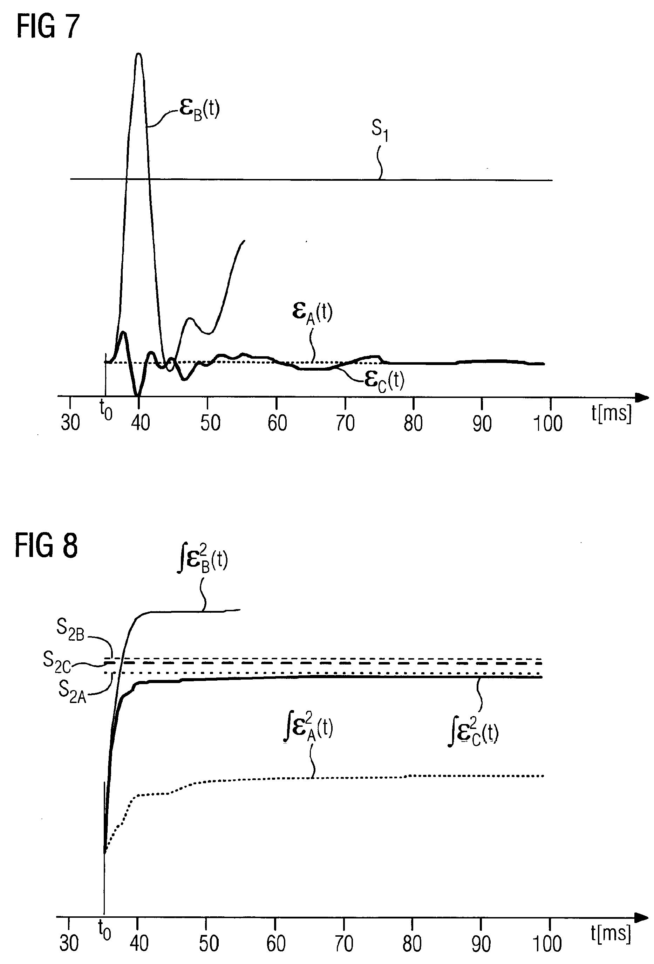

Das Ergebnis der Berechnungen des Abweichungs-Kennwertes $\varepsilon_B(t)$ für den Abgang 12b ist in Figur 7 beispielhaft dargestellt. Da der verwendete Nullsystemkapazitäts-Wert $C_{0B}$ für das Zeitfenster $t_0 + 20ms$ bestimmt wurde, endet der Verlauf des fraglichen Abweichungs-Kennwertes $\varepsilon_B(t)$ ebenfalls entsprechend. Zum Vergleich sind in Figur 7 auch die Abweichungs-Kennwerte $\varepsilon_A(t)$ und $\varepsilon_C(t)$ dargestellt, die sich für die Abgänge 12a und 12c ergeben würden.

Die Größe des Abweichungs-Kennwertes $\varepsilon(t)$ erlaubt es, zwischen einem gesunden und einem fehlerbehafteten Abschnitt des Energieversorgungsnetzes zu unterscheiden. Hierzu wird in einem folgenden Schritt 28 der Abweichungs-Kennwert $\varepsilon(t)$ mit einem ersten Abweichungs-Schwellenwert $S_1$ verglichen. Dieser erste Abweichungs-Schwellenwert $S_1$ ist in Figur 7 beispielhaft eingetragen und kann z.B. einen Wert von 100V annehmen.

Ergibt die Prüfung in Schritt 28, dass der erste Abweichungs-Schwellenwert $S_1$ überschritten worden ist, so wird in einem abschließenden Schritt 29 ein den erkannten Erdfehler auf dem betreffenden Abgang 12b angebendes Fehlersignal erzeugt. Dieses kann z.B. dazu verwendet werden, um einen den fehlerbehafteten Abgang 12b mit der Sammelschiene 11 verbindenden (in Figur 1 nicht gezeigten) Schalter zum Öffnen seiner Schaltkontakte zu veranlassen.

Alternativ oder zusätzlich kann das Fehlersignal auch an den Betreiber des Energieversorgungsnetzes gemeldet werden, um ihn auf den Erdfehler hinzuweisen, so dass der Betreiber ggf. eine Behebung des Erdfehlers veranlassen kann.

Wird in Schritt 28 hingegen keine Überschreitung des ersten Abweichungsschwellenwertes $S_1$ festgestellt, so wird das Verfahren bei Schritt 20 mit der Aufnahme weiterer Nullsystemstrom- und Nullsystemspannungs-Messwerte fortgesetzt.

Um das beschriebene Verfahren noch empfindlicher auszugestalten kann in Schritt 27 alternativ oder zusätzlich zum Vergleich der Abweichungs-Kennwerte $\varepsilon(t)$ mit dem ersten Abweichungs-Schwellenwert $S_1$ auch eine Quadrierung der Abweichungs-Kennwerte und eine anschließende Integralbildung stattfinden:

$$\int \varepsilon^2(t) \, dt \qquad\qquad (4)$$

Dieses Integral der quadrierten Abweichungs-Kennwerte wird dann in Schritt 28 mit einem zweiten Abweichungs-Schwellenwert $S_2$ verglichen. In Figur 8 ist das Ergebnis der Bildung des Integrals über die quadrierten Abweichungs-Kennwerte $\varepsilon_B^2(t)$ für den zweiten Abgang 12b beispielhaft dargestellt. Als Grenzen für die Integralbildung wurden wieder die bereits benannten Fenstergrenzen $t_0$ und $t_0 + 20ms$ verwendet. Dieses Integral wird mit einem zweiten Abweichungs-Schwellenwert $S_{2B}$ verglichen, der beispielsweise den inversen Wert der für den zweiten Abgang 12b ermittelten Nullsystemkapazität $1/C_{0B}$ oder einen dazu proportionalen Wert aufweisen kann. Der Wertebereich, den der zweite Abweichungs-Schwellenwert annehmen kann, kann zudem nach oben und unten begrenzt sein. Wenn der zweite Abweichungs-Schwellenwert $S_2$ - wie in Figur 8 gezeigt - von dem Integral überschritten wird, wird ebenfalls in Schritt 29 das Fehlersignal erzeugt.

Durch die Bildung des Integrals über die quadrierten Abweichungs-Kennwerte kann die Empfindlichkeit des erfindungsgemäßen Verfahrens weiter erhöht werden, da hierbei eine Betrachtung über eine längere Zeit durchgeführt werden kann. Durch die Quadrierung der Abweichungskennwerte können starke Abweichungen gegenüber kleineren betont werden; die zeitliche Integration über aufeinander folgende Abweichungskennwerte erlaubt zudem auch die Erkennung sich nur durch geringe Abweichungen auswirkender Erdfehler. Um eine Fehlentscheidung aufgrund eines allmählichen Driftens des zeitlichen Integrals über die quadrierten Abweichungs-Kennwerte in Richtung des zweiten Abweichungs-Schwellenwertes $S_2$ zu verhindern, kann zudem vorgesehen sein, dass das zeitliche Integral über das Quadrat der Abweichungskennwerte nach Ablauf einer vorgegebenen Überwachungszeitdauer auf Null zurückgesetzt wird. Als Überwachungszeitdauer kann beispielsweise die Dauer von 5 Zyklen der Grundschwingung des Stromes (bei einer Grundschwingung von 50Hz also 100 Millisekunden) verwendet werden. Nach dem Zurücksetzen wird die Bildung des Intergrals erneut gestartet.

Um die Empfindlichkeit des Verfahrens dynamisch an die jeweilige Fehlersituation anpassen zu können, kann zudem vorgesehen sein, dass der Gradient des Verlaufs der Nullsystemstrom-Messwerte untersucht wird und der Wert des zweiten Abweichungs-Schwellenwertes derart dynamisch an den Wert des Gradienten angepasst wird, dass bei einem hohen Gradienten ein höherer Wert für den zweiten Abweichungs-Schwellenwert verwendet wird als bei einem niedrigen Gradienten.

Hierdurch kann eine Anpassung der Empfindlichkeit der Erkennung eines Erdfehlers an die jeweilige Fehlersituation stattfinden. Hierzu werden die transienten Vorgänge im Verlauf der Nullsystemstrom-Messwerte betrachtet. Bei einem niederohmigen Erdfehler wird nämlich zum Fehlerbeginn ein hoher Gradient des Verlaufes der Nullsystemstrom-Messwerte auftreten, während der Gradient bei einem hochohmigen Erdfehler eher moderat verläuft. Hierdurch kann eine automatische Erkennung der Fehlersituation erfolgen. Um bei einem niederohmigen Erdfehler die Erkennung möglichst robust zu halten und nicht zu früh ein Fehlersignal zu erzeugen, wird der zweite Abweichungs-Schwellenwert in diesem Fall höher angesetzt als bei einem hochohmigen Erdfehler, bei dem das Verfahren mit höchstmöglicher Empfindlichkeit arbeiten soll. Die Betrachtung des Gradienten kann auf Momentanwertbasis erfolgen oder unter Verwendung von Mittelwerter (z.B. RMS-Werten) durchgeführt werden.

Um eine Fehlentscheidung bei der Erdfehlererkennung aufgrund für die Auswertung nicht geeigneter Nullsystemstrom- und/oder Nullsystemspannungs-Messwerte zu vermeiden, kann nach der Erfassung der Nullsystemstrom- und der Nullsystemspannungs-Messwerte außerdem eine Überprüfung der Höhe aufgenommenen Messwerte stattfinden und das Verfahren dann unterbrochen werden, wenn ein Mittelwert der Nullsystemstrom-Messwerte unter einem vorgegebenen Minimalstrom-Schwellenwert und/oder ein Mittelwert der Nullsystemspannungs-Schwellenwerte unter einem vorgegebenen Minimalspannungs-Schwellenwert liegt. Der jeweilige Mittelwert kann beispielsweise als RMS-Wert (RMS = root mean square) bestimmt werden.

Schließlich kann die Genauigkeit der Erkennung eines Erdfehlers dadurch noch erhöht werden, dass die Schutzgeräte 14a-c auch eine explizite Richtungserkennung hinsichtlich des Erdfehlers durchführen. Zur Erkennung der Richtung, in der der Erdfehler von der jeweiligen Messstelle 16a-c aus gesehen aufgetreten ist, wird für eine vorgegebene Betrachtungszeitdauer ab dem Startzeitpunkt eine Nullsystemwirkenergie ermittelt und mit einem Wirkenergie-Schwellenwert verglichen, und ein in Vorwärtsrichtung auf dem überwachten Abschnitt liegender Erdfehler wird dann erkannt, wenn die ermittelte Nullsystemwirkenergie den negativen Wert des Wirkenergie-Schwellenwertes unterschreitet, während ein in Rückwärtsrichtung außerhalb des überwachten Abschnitts liegender Erdfehler dann erkannt wird, wenn die ermittelte Nullsystemwirkenergie den positiven Wert des Wirkenergie-Schwellenwertes überschreitet. Die Nullsystemwirkenergie kann durch Integration einer Nullsystemwirkleistung berechnet werden; die Nullsystemwirkleistung kann durch Multiplikation der Nullsystemstrom-Messwerte und der Nullsystemspannungs-Messwerte einfach berechnet werden. Als Betrachtungszeitdauer kann beispielsweise das bekannte Zeitfenster von $t_0$ bis $t_0$ + 20ms verwendet werden.

Mit jeder Erfassung eines neuen Messwertes für den Nullsystemstrom und die Nullsystemspannung wird das Verfahren inkrementell fortgesetzt, d.h. jeder neue Messwert wird in die Ermittlung des Verlaufs der Nullsystemladungs-Werte und des Nullsystemkapazitäts-Wertes einbezogen. Etwaige verwendete Zeitfenster werden entsprechend gleitend mitgezogen.

**Patentansprüche**

1. Verfahren zum Erkennen eines Erdfehlers in einem mehrphasigen elektrischen Energieversorgungsnetz (10) mit kompensiertem oder isoliertem Sternpunkt, bei dem folgende Schritte durchgeführt werden:

- Erfassen von Nullsystemstrom- und Nullsystemspannungs-Messwerten, die einen an einer Messstelle (16a-c) vorliegenden Nullsystemstrom und eine Nullsystemspannung angeben, mittels eines elektrischen Schutzgerätes (14a-c), wobei die Messstelle (16a-c) im Bereich eines von dem Schutzgerät überwachten Abschnitts des Energieversorgungsnetzes (10) angeordnet ist;
- Speichern der erfassten Nullsystemstrom- und Nullsystemspannungs-Messwerte in einem Messwertspeicher des Schutzgerätes (14a-c);
- Vergleichen der Nullsystemspannungs-Messwerte mit einem Nullsystemspannungs-Schwellenwert und Erzeugen eines Triggersignals, wenn ein Nullsystemspannungs-Messwert den Nullsystemspannungs-Schwellenwert übersteigt;
- Auswählen eines Verlaufs von Nullsystemstrom-Messwerten aus dem Messwertspeicher bei vorliegendem Triggersignal;
- Berechnen eines Verlaufs von Nullsystemladungs-Werten aus dem Verlauf der ausgewählten Nullsystemstrom-Messwerte; und
- Heranziehen des Verlaufs der Nullsystemladungs-Werte zum Erkennen eines Erdfehlers in dem überwachten Abschnitt; **dadurch gekennzeichnet, dass** zum Erkennen eines Erdfehlers
- unter Verwendung des Verlaufs von Nullsystemladungs-Werten und zugehörigen Nullsystemspannungs-Messwerten ein Nullsystemkapazitäts-Wert für den überwachten Abschnitt bestimmt wird;
- unter Verwendung des Verlaufs von Nullsystemladungs-Werten und des Nullsystemkapazitäts-Wertes einerseits, sowie der zugehörigen Nullsystemspannungs-Messwerte andererseits, ein Abweichungskennwert gebildet wird; und
- ein auf einen Erdfehler auf dem überwachten Abschnitt hinweisendes Fehlersignal erzeugt wird, wenn der Abweichungskennwert einen vorgegebenen ersten Abweichungs-Schwellenwert übersteigt.

2. Verfahren nach Anspruch 1,
**dadurch gekennzeichnet, dass**

- zur Bildung des Abweichungskennwertes der Quotient der Nullsystemladungs-Werte und des Nullsystemkapazitäts-Wertes gebildet und dieser von den zeitlich zugehörigen Nullsystemspannungs-Messwerten abgezogen wird.

3. Verfahren nach einem der Ansprüche 1 oder 2,
**dadurch gekennzeichnet, dass**

- als Startzeitpunkt, zu dem der ausgewählte Verlauf der Nullsystemstrom-Messwerte beginnt, entweder derjenige Zeitpunkt gewählt wird, zu dem der letzte Nulldurchgang der Nullsystemspannungs-Messwerte stattgefunden hat, oder derjenige Zeitpunkt gewählt wird, der eine vorgegebene Zeitdauer vor dem Zeitpunkt liegt, zu dem die Überschreitung des Nullsystemspannungs-Schwellenwertes stattgefunden hat.

4. Verfahren nach Anspruch 3,

**dadurch gekennzeichnet, dass**

- der Verlauf der Nullsystemladungs-Werte durch numerische zeitliche Integration des Verlaufs der Nullsystemstrom-Messwerte ab dem Startzeitpunkt ermittelt wird.

5. Verfahren nach einem der Ansprüche 3 oder 4,
**dadurch gekennzeichnet, dass**

- der Nullsystemkapazitäts-Wert aus einem über ein Zeitfenster festgelegten Bereich der Nullsystemladungs-Werte und der zugehörigen Nullsystemspannungs-Messwerte gebildet wird, wobei das Zeitfenster zum Startzeitpunkt beginnt und nach Ablauf einer vorgegebenen Fensterzeit endet.

6. Verfahren nach Anspruch 5,
**dadurch gekennzeichnet, dass**

- der Nullsystemkapazitäts-Wert mittels eines Least-Square-Schätzverfahrens aus den Nullsystemladungs-Werten und den zeitlich zugehörigen Nullsystemspannungs-Messwerten bestimmt wird.

7. Verfahren nach einem der vorangehenden Ansprüche,
**dadurch gekennzeichnet, dass**

- der Nullsystemkapazitäts-Wert mit einem oberen und einem unteren Kapazitäts-Schwellenwert verglichen wird; und
- bei Überschreitung des oberen Kapazitäts-Schwellenwertes der Wert des oberen Kapazitäts-Schwellenwertes und bei Unterschreitung des unteren Kapazitäts-Schwellenwertes der Wert des unteren Kapazitäts-Schwellenwertes als Nullsystemkapazitäts-Schwellenwert verwendet wird.

8. Verfahren nach einem der vorangehenden Ansprüche,
**dadurch gekennzeichnet, dass**

- ein zeitliches Integral über das Quadrat der jeweils ermittelten Abweichungskennwerte gebildet wird; und
- das Fehlersignal auch dann erzeugt wird, wenn das zeitliche Integral über das Quadrat der Abweichungskennwerte einen vorgegeben zweiten Abweichungs-Schwellenwert übersteigt.

9. Verfahren nach einem der Anspruch 8,
**dadurch gekennzeichnet, dass**

- der Gradient des Verlaufs der Nullsystemstrom-Messwerte untersucht wird und der Wert des zweiten Abweichungs-Schwellenwertes derart dynamisch an den Wert des Gradienten angepasst wird, dass bei einem hohen Gradienten ein höherer Wert für den zweiten Abweichungs-Schwellenwert verwendet wird als bei einem niedrigen Gradienten.

10. Verfahren nach Anspruch 8 oder 9,
**dadurch gekennzeichnet, dass**

- das zeitliche Integral über das Quadrat der Abweichungskennwerte nach Ablauf einer vorgegebenen Überwachungszeitdauer auf Null zurückgesetzt wird.

11. Verfahren nach einem der vorangehenden Ansprüche,
**dadurch gekennzeichnet, dass**

- das Verfahren dann unterbrochen wird, wenn ein Mittelwert der Nullsystemstrom-Messwerte unter einem vorgegebenen Minimalstrom-Schwellenwert und/oder ein Mittelwert der Nullsystemspannungs-Schwellenwerte unter einem vorgegebenen Minimalspannungs-Schwellenwert liegt.

12. Verfahren nach einem der Ansprüche 3 bis 11, **dadurch gekennzeichnet, dass**

- zur Erkennung einer Richtung, in der der Erdfehler von der Messstelle (16a-c) aus gesehen aufgetreten ist, für eine vorgegebene Betrachtungszeitdauer ab dem Startzeitpunkt eine Nullsystemwirkenergie ermittelt und mit einem Wirkenergie-Schwellenwert verglichen wird;
- ein in Vorwärtsrichtung auf dem überwachten Abschnitt liegender Erdfehler dann erkannt wird, wenn die ermittelte Nullsystemwirkenergie den negativen Wirkenergie-Schwellenwert unterschreitet; und
- ein in Rückwärtsrichtung außerhalb des überwachten Abschnitts liegender Erdfehler dann erkannt wird, wenn die ermittelte Nullsystemwirkenergie den positiven Wirkenergie-Schwellenwert überschreitet.

13. Schutzgerät (14a-c) zum Erkennen eines Erdfehlers in einem mehrphasigen elektrischen Energieversorgungsnetz (10) mit kompensiertem oder isoliertem Sternpunkt mit einer Steuereinrichtung, die zur Durchführung eines Verfahrens gemäß einem der Ansprüche 1 bis 12 eingerichtet ist.

14. Verwendung eines Schutzgerätes (14a-c) gemäß Anspruch 12 zur Überwachung eines Abgangs (12a-c) in einem elektrischen Energieversorgungsnetz (10) mit kompensiertem oder isoliertem Sternpunkt auf einen Erdfehler.

**Claims**

1. Method for identifying a ground fault in a polyphase electrical power supply system (10) having a compensated or isolated star point, wherein the following steps are carried out:

   - detecting zero phase sequence system current and zero phase sequence system voltage measurement values indicating a zero phase sequence system current and a zero phase sequence system voltage present at a measurement location (16a-c), by means of an electrical protective device (14a-c), wherein the measurement location (16a-c) is arranged in the region of a section of the power supply system (10) which is monitored by the protective device;
   - storing the detected zero phase sequence system current and zero phase sequence system voltage measurement values in a measurement value memory of the protective device (14a-c);
   - comparing the zero phase sequence system voltage measurement values with a zero phase sequence system voltage threshold value and generating a trigger signal if a zero phase sequence system voltage measurement value exceeds the zero phase sequence system voltage threshold value;
   - selecting a profile of zero phase sequence system current measurement values from the measurement value memory in the case where the trigger signal is present;
   - calculating a profile of zero phase sequence system charge values from the profile of the selected zero phase sequence system current measurement values; and
   - using the profile of the zero phase sequence system charge values for identifying a ground fault in the monitored section;

   **characterized in that**
   for identifying a ground fault

   - using the profile of zero phase sequence system charge values and associated zero phase sequence system voltage measurement values, a zero phase sequence system capacitance value is determined for the monitored section;
   - using the profile of zero phase sequence system charge values and the zero phase sequence system capacitance value, on the one hand, and the associated zero phase sequence system voltage measurement values, on the other hand, a deviation characteristic value is formed; and
   - a fault signal indicating a ground fault on the monitored section is generated if the deviation characteristic value exceeds a predetermined first deviation threshold value.

2. Method according to Claim 1,
   **characterized in that**

   - for forming the deviation characteristic value, the quotient of the zero phase sequence system charge values and the zero phase sequence system capacitance value is formed and this is subtracted from the temporally associated zero phase sequence system voltage measurement values.

3. Method according to either of Claims 1 and 2,
   **characterized in that**

- as a start instant at which the selected profile of the zero phase sequence system current measurement values begins, either that instant is chosen at which the last zero crossing of the zero phase sequence system voltage measurement values took place, or that instant is chosen which precedes, by a predetermined time duration, the instant at which the exceeding of the zero phase sequence system voltage threshold value took place.

4. Method according to Claim 3,
   **characterized in that**

   - the profile of the zero phase sequence system charge values is determined by numerical temporal integration of the profile of the zero phase sequence system current measurement values starting from the start instant.

5. Method according to either of Claims 3 and 4,
   **characterized in that**

   - the zero phase sequence system capacitance value is formed from a range of the zero phase sequence system charge values and of the associated zero phase sequence system voltage measurement values, said range being defined by means of a time window - wherein the time window begins at the start instant and ends after a predetermined window time has elapsed.

6. Method according to Claim 5,
   **characterized in that**

   - the zero phase sequence system capacitance value is determined by means of a least squares estimation method from the zero phase sequence system charge values and the temporally associated zero phase sequence system voltage measurement values.

7. Method according to any of the preceding claims,
   **characterized in that**

   - the zero phase sequence system capacitance value is compared with an upper and a lower capacitance threshold value; and
   - when the upper capacitance threshold value is exceeded, the value of the upper capacitance threshold value is used as zero phase sequence system capacitance threshold value and, when the lower capacitance threshold value is undershot, the value of the lower capacitance threshold value is used as zero phase sequence system capacitance threshold value.

8. Method according to any of the preceding claims,
   **characterized in that**

   - a temporal integral over the square of the deviation characteristic values respectively determined is formed; and
   - the fault signal is also generated when the temporal integral over the square of the deviation characteristic values exceeds a predetermined second deviation threshold value.

9. Method according to Claim 8,
   **characterized in that**

   - the gradient of the profile of the zero phase sequence system current measurement values is examined and the value of the second deviation threshold value is dynamically adapted to the value of the gradient in such a way that a higher value for the second deviation threshold value is used in the case of a high gradient than in the case of a low gradient.

10. Method according to Claim 8 or 9,
    **characterized in that**

    - the temporal integral over the square of the deviation characteristic values is reset to zero after a predetermined monitoring time duration has elapsed.

11. Method according to any of the preceding claims,

**characterized in that**

- the method is interrupted when an average value of the zero phase sequence system current measurement values lies below a predetermined minimum current threshold value and/or an average value of the zero phase sequence system voltage threshold values lies below a predetermined minimum voltage threshold value.

12. Method according to any of Claims 3 to 11,
**characterized in that**

- for identifying a direction in which the ground fault occurred as seen from the measurement location (16a-c), for a predetermined observation time duration starting from the start instant, a zero phase sequence system active energy is determined and compared with an active energy threshold value;
- a ground fault lying on the monitored section in the forward direction is identified when the zero phase sequence system active energy determined falls below the negative active energy threshold value; and
- a ground fault lying outside the monitored section in the reverse direction is identified when the zero phase sequence system active energy determined exceeds the positive active energy threshold value.

13. Protective device (14a-c) for identifying a ground fault in a polyphase electrical power supply system (10) having a compensated or isolated star point comprising a control device designed for carrying out a method according to any of Claims 1 to 12.

14. Use of a protective device (14a-c) according to Claim 13 for monitoring an outgoer (12a-c) in an electrical power supply system (10) having a compensated or isolated star point for a ground fault.

**Revendications**

1. Procédé de détection d'un défaut à la terre dans un réseau ( 10 ) d'alimentation en énergie électrique polyphasé ayant un point neutre compensé ou isolé, dans lequel on effectue les stades suivants :

- détection de valeurs de mesure de courant de système nul et de tension de système nulle, qui indiquent un courant de système nul ou une tension de système nulle en un point ( 16a à 16c ) de mesure au moyen d'un appareil ( 14a à 14c ) de protection électrique, le point ( 16a à 16c ) de mesure étant dans la partie d'un tronçon, contrôlé par l'appareil de protection, du réseau ( 10 ) d'alimentation en énergie ;
- mémorisation des valeurs de mesure de courant de système nul et de tension de système nulle dans une mémoire de valeurs de mesure de l'appareil ( 14a à 14c ) de protection ;
- comparaison des valeurs de mesure de tension de système nulle à une valeur de seuil de tension de système nulle et production d'un signal de déclenchement si une valeur de mesure de tension de système nulle dépasse la valeur de seuil de tension de système nulle ;
- sélection d'une courbe de valeurs de mesure de courant de système nul dans la mémoire de valeurs de mesure en présence du signal de déclenchement ;
- calcul d'une courbe de valeurs de charge de système nulle à partir de la courbe des valeurs de mesure de courant de système nul sélectionnées et
- mise à profit de la courbe des valeurs de charge de système nulle pour détecter un défaut à la terre dans le tronçon contrôlé,

**caractérisé en ce que**, pour détecter un défaut à la terre

- on détermine, en utilisant la courbe des valeurs de charge de système nulle et des valeurs de mesure associées de tension de système nulle, une valeur de capacité de système nulle pour le tronçon contrôlé ;
- on forme, en utilisant la courbe des valeurs de charge de système nulle et la valeur de capacité de système nulle, d'une part, ainsi que les valeurs de mesure de tension de système nulle associées, d'autre part, une valeur caractéristique d'écart et
- on produit un signal de défaut indiquant un défaut à la terre sur le tronçon contrôlé, si la valeur caractéristique d'écart dépasse une première valeur de seuil d'écart donnée à l'avance.

2. Procédé suivant la revendication 1,
**caractérisé en ce que**

- pour former la valeur caractéristique d'écart, on forme le quotient des valeurs de charge de système nulle par la valeur de capacité de système nulle et on déduit celui-ci des valeurs de mesure de tension de système nulle associées dans le temps.

3. Procédé suivant la revendication 1 ou 2,
   **caractérisé en ce que**

   - on sélectionne, comme instant de début où commence la courbe sélectionnée des valeurs de mesure de courant de système nul, soit l'instant où le dernier passage à zéro des valeurs de mesure de tension de système nulle a eu lieu, soit l'instant qui se trouve à une durée donnée à l'avance avant l'instant où le dépassement de la valeur de seuil de la tension de système nulle a eu lieu.

4. Procédé suivant la revendication 3,
   **caractérisé en ce que**

   - on détermine la courbe des valeurs de tension de système nulle par un intégration numérique en fonction du temps de la courbe des valeurs de mesure de courant de système nul à partir de l'instant de début.

5. Procédé suivant l'une des revendications 3 ou 4,
   **caractérisé en ce que**

   - on forme la valeur de capacité de système nulle à partir d'une partie, fixée par un créneau temporel, des valeurs de charge de système nulle et des valeurs de mesure de tension de système nulle associées, le créneau temporel commençant à l'instant de début et se terminant après l'écoulement d'un créneau temporel donné à l'avance.

6. Procédé suivant la revendication 5,
   **caractérisé en ce que**

   - on détermine la valeur de capacité de système nulle au moyen d'un procédé d'estimation par les moindres carrés à partir des valeurs de charge de système nulle et des valeurs de mesure de tension de système nulle associées dans le temps.

7. Procédé suivant l'une des revendications précédentes,
   **caractérisé en ce que**

   - on compare la valeur de capacité de système nulle à une valeur de seuil de capacité supérieure et à une valeur de seuil de capacité inférieure et
   - si la valeur de seuil de la capacité supérieure est dépassée, on utilise la valeur de la valeur de seuil de la capacité supérieure et, si l'on est en dessous de la valeur de seuil de la capacité inférieure, on utilise la valeur de la valeur de seuil de la capacité inférieure comme valeur de seuil de capacité de système nulle.

8. Procédé suivant l'une des revendications précédentes,
   **caractérisé en ce que**

   - on forme une intégrale en fonction du temps sur le carré des valeurs caractéristiques d'écart déterminées et
   - on produit le signal de défaut, même si l'intégrale en fonction du temps sur le carré des valeurs caractéristiques d'écart dépasse une deuxième valeur de seuil d'écart donnée à l'avance.

9. Procédé suivant la revendication 8,
   **caractérisé en ce que**

   - on recherche le gradient de la courbe des valeurs de mesures du courant de système nul et on adapte la valeur de la deuxième valeur de seuil d'écart dynamiquement à la valeur du gradient, de manière à utiliser, pour un gradient grand, une valeur, pour la deuxième valeur de seuil d'écart, plus grande que pour un gradient petit.

10. Procédé suivant la revendication 8 ou 9,

**caractérisé en ce que**

- on ramène à zéro l'intégrale en fonction du temps sur le carré des valeurs caractéristiques d'écart après l'écoulement d'une durée de contrôle donnée à l'avance.

11. Procédé suivant l'une des revendications précédentes,
**caractérisé en ce que**

- on interrompt le procédé si une valeur moyenne des valeurs de mesure de courant de système nul est inférieure à une valeur de seuil de courant minimum donnée à l'avance et/ou si une valeur moyenne des valeurs de seuil de tension de système nulle est inférieure à une valeur de seuil de tension minimum donnée à l'avance.

12. Procédé suivant l'une des revendications 3 à 11,
**caractérisé en ce que**

- pour détecter un sens dans lequel le défaut à la terre s'est produit, considéré à partir du point ( 16a à 16c ) de mesure, on détermine, pendant une durée de prise en considération donnée à l'avance à partir de l'instant de début, une énergie active de système nulle et on la compare à une valeur de seuil d'énergie active ;
- on détecte un défaut à la terre allant dans la direction vers l'avant sur le tronçon contrôlé, si l'énergie active de système nulle déterminée est inférieure à la valeur de seuil d'énergie active négative et
- on détecte un défaut à la terre se trouvant dans le sens allant vers l'arrière à l'extérieur du tronçon contrôlé, si l'énergie active de système nulle déterminée dépasse la valeur de seuil d'énergie active positive.

13. Appareil ( 14a à 14c ) de protection pour détecter un défaut à la terre dans un réseau ( 10 ) d'alimentation en énergie électrique polyphasé ayant un point neutre compensé ou isolé, comprenant un dispositif de commande qui est conçu pour effectuer un procédé suivant l'une des revendications 1 à 12.

14. Utilisation d'un appareil ( 14a à 14c ) de protection suivant la revendication 12, pour le contrôle d'un défaut à la terre sur une sortie ( 12a à 12c ) d'un réseau ( 10 ) d'alimentation en énergie électrique ayant un point neutre compensé ou isolé.

FIG 1

## FIG 2

```
20 —— [  i_0(t)      u_0(t)  ]

21 —— [     speichern     ]

22 —— <  u_0(t) > S_{U0} ?  >  — n

        j

23 —— [      Trigger      ]

24 —— [       i_0(t)      ]

25 —— [       q_0(t)      ]

26 —— [        C_0        ]

27 —— [       ε(t)        ]

28 —— <  ε(t) > S_1 ?
           oder
        ∫ε²(t)dt > S_2 ? >  — n

        j

29 —— [    Fehlersignal   ]
```

Node 20: $i_0(t)$ $u_0(t)$

Node 22: $u_0(t) > S_{U0}$?

Node 24: $i_0(t)$

Node 25: $q_0(t)$

Node 26: $C_0$

Node 27: $\varepsilon(t)$

Node 28: $\varepsilon(t) > S_1$? oder $\int \varepsilon^2(t)\,dt > S_2$?

FIG 3

FIG 4

## FIG 5

## FIG 6

## FIG 7

## FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10302451 B3